# EUROPÄISCHE PATENTANMELDUNG

(11) **EP 1 944 998 A2**
(43) Veröffentlichungstag der Anmeldung: **16.07.2008**
(21) Anmeldenummer: 07124093.1
(22) Anmeldetag: 27.12.2007
(51) Int. Cl.: H04R 1/10, H04R 5/033, H04R 25/00

(54) **Hörvorrichtung mit automatischer Selbsttrimmung und entsprechendes Verfahren**

(30) Priorität: 10.01.2007 DE 102007001538
(71) Anmelder: Siemens Audiologische Technik GmbH, 91058 Erlangen (DE)
(72) Erfinder: Pfannenmüller, Gerhard, 90522 Oberasbach (DE); Rückerl, Gottfried, 90461 Nürnberg (DE); Sauer, Gunter, 91052 Erlangen (DE); Schätzle, Ulrich, 91301 Forchheim (DE)
(74) Vertreter: Maier, Daniel Oliver

(57) **Zusammenfassung**

Eine LC-Oszillatorschaltung einer Hörvorrichtung soll dauerhaft in einem gewünschten Frequenzbereich betrieben werden können. Hierzu wird eine Hörvorrichtung mit einem Oszillator (L, Cᵣₑₛ) und einer Trimmeinrichtung (11, 12) zum Trimmen der Oszillationsfrequenz des Oszillators vorgeschlagen. Eine Regeleinrichtung (19) regelt die Oszillationsfrequenz des Oszillators mit Hilfe der Trimmeinrichtung (11, 12) entsprechend einem vorgegebenen Sollwert. Damit ist ein automatisches Selbsttrimmen eines drahtlosen Übertragungssystems in einer Hörvorrichtung und insbesondere in einem Hörgerät möglich.

## Beschreibung

Die vorliegende Erfindung betrifft eine Hörvorrichtung mit einem Oszillator und einer Trimmeinrichtung zum Trimmen der Oszillationsfrequenz des Oszillators. Darüber hinaus betrifft die vorliegende Erfindung ein entsprechendes Verfahren zum Steuern einer Hörvorrichtung. Unter einer Hörvorrichtung wird hier insbesondere ein Hörgerät, aber auch jedes andere tragbare Audiogerät wie Kopfhörer, Headset und dergleichen verstanden.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Indem-Ohr-Hörgeräte (IdO) und Concha-Hörgeräte bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

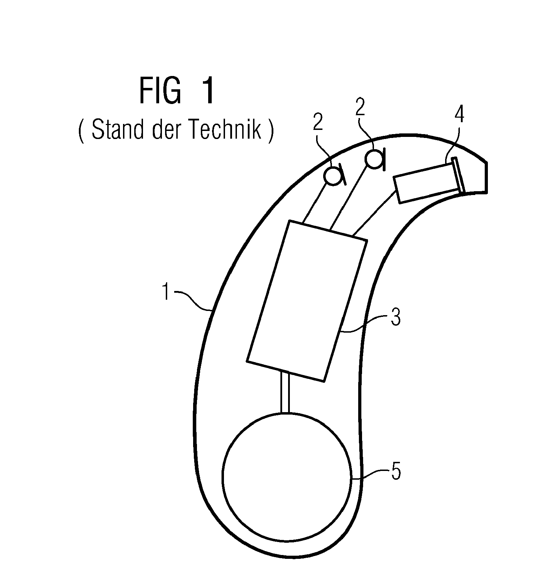

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Stromversorgung des Hörgeräts und insbesondere die der Signalverarbeitungseinheit 3 erfolgt durch eine ebenfalls ins Hörgerätegehäuse 1 integrierte Batterie 5.

Zur energieeffizienten Realisierung einer drahtlosen Datenübertragung zwischen Hörgeräten werden modulierbare LC-Oszillatorschaltungen eingesetzt. Der LC-Kreis kann dabei sowohl für den Empfang als auch für das Senden verwendet werden. Die frequenzbestimmenden Bauelemente derartiger Schaltungen müssen jedoch exakt auf die Sollwerte abgestimmt werden. Abweichungen vom Sollwert, die durch Fertigungstoleranzen begründet sind, können durch eine einmalige Trimmung des Resonanzkreises während des Fertigungsprozesses korrigiert werden. Der Einfluss von Temperatureffekten und Parameterdrift durch Alterung wird dadurch jedoch nicht abgedeckt. Spezielle Modulationsverfahren wie z. B. QPSK oder BPSK erfordern aber eine hohe Absolutgenauigkeit der Frequenz, die auch eine Kompensation von Temperatureffekten und Alterung zwingend nötig machen.

Bei Hörgeräten, die ausschließlich drahtlos programmierbar sein sollen (ohne herkömmliche Programmierschnittstelle) besteht außerdem das Problem, dass die drahtlose Programmierung nur dann möglich ist, wenn der LC-Kreis der drahtlosen Hörgeräte- Sende/Empfangsschaltung bereits richtig getrimmt ist. Eine Steuerung der Trimmung durch ein externes Programmiergerät ist dadurch nicht möglich.

Bei bisherigen Hörgeräten wird zur Datenübertragung ein Modulationsverfahren eingesetzt, dessen Genauigkeitsanforderungen mit einer einmaligen Trimmung in der Fertigung erfüllt werden können. Dabei wird der LC-Oszillator gestartet und durch einen auf den Hörgerätechips integrierten Frequenzzähler die aktuelle Oszillatorfrequenz gemessen. Dieser Messwert kann dann über die Programmierschnittstelle ausgelesen werden. Aus der Abweichung zum Sollwert ermittelt der für die Programmierung verwendete PC den zur Kompensation erforderlichen Kapazitätswert. Appliziert wird dieser Kapazitätswert durch eine ebenfalls auf den Chips integrierte programmierbare Kapazitätsmatrix, die nun ebenfalls durch den PC über die Programmierschnittstelle konfiguriert wird.

Aus Tietze, U.; Schenk; Ch.: Halbleiter-Schaltungstechnik, 11. Aufl., Berlin [u.a.]: Springer, 1999, S. 1284 - 1286, ISBN 3-540-64192-0 ist eine Nachlaufsynchronisation (Phase-Locked-Loop; PLL) bekannt. Ihre Aufgabe besteht darin die Frequenz eines Oszillators so einzustellen, dass sie mit der Frequenz eines Bezugsoszillators übereinstimmt, und zwar so genau, dass die Phasenverschiebung nicht wegläuft. Ein Nachlaufoszillator lässt sich beispielsweise mit Hilfe eines spannungsgesteuerten Oszillators realisieren

Weiterhin ist aus dem Artikel Kral, A.; Behbahani, F.; Abidi, A.A.: RF-CMOS oscillators with switched tuning. In: Proceedings of the IEEE 1998, Custom Integrated Circuits Conference, 1998, S. 555-558 ein RF-CMOS-Oszillator bekannt, der mit einem zuschaltbarem Kondensator getunt werden kann.

Die Aufgabe der vorliegenden Erfindung besteht somit darin, dauerhaft eine hohe Genauigkeit der Trimmung des Resonanzkreises aufrecht zu erhalten.

Erfindungsgemäß wird diese Aufgabe gelöst durch eine Hörvorrichtung mit einem Oszillator und einer Trimmeinrichtung zum Trimmen der Oszillationsfrequenz des Oszillators, sowie einer Regeleinrichtung zum automatischen Regeln der Oszillationsfrequenz des Oszillators mit Hilfe der Trimmeinrichtung in Abhängigkeit von einem vorgegebenen Sollwert.

Darüber hinaus wird erfindungsgemäß bereitgestellt ein Verfahren zum Steuern einer Hörvorrichtung durch Steuern einer Datenverarbeitung der Hörvorrichtung mit einem Oszillator und Trimmen der Oszillationsfrequenz des Oszillators, wobei das Trimmen ein automatisches Regeln der Oszillationsfrequenz des Oszillators in Abhängigkeit von einem vorgegebenen Sollwert umfasst.

In vorteilhafter Weise ist damit eine automatische Selbsttrimmung beispielsweise eines drahtlosen Übertragungssystems eines Hörgeräts möglich. Es ist nicht notwendig, für ein einfaches Trimmen einen Hörgerätespezialisten aufzusuchen.

Vorzugsweise besitzt der Oszillator der Hörvorrichtung einen LC-Schwingkreis, dessen Resonanzkapazität durch eine Kapazitätsmatrix der Trimmeinrichtung trimmbar ist. Die automatische Anpassung der Matrix der Trimmkapazitäten ermöglicht eine einfache, weitgehend automatisierte Grundtrimmung in der Fertigung. Die erforderliche Software kann sehr stark vereinfacht werden, da nur noch wenige Steuerbefehle erforderlich sind.

Die Regeleinrichtung kann einen Frequenzzähler, einen Fensterkomparator und eine Ablaufsteuereinheit aufweisen. Mit diesen Komponenten lässt sich der Regelkreis einfach aufbauen.

Gemäß einer speziellen Ausführungsform stellt die Resonanzspule des LC-Schwingkreises eine Sende- und Empfangsantenne dar. Dadurch erhält die Resonanzspule eine Mehrfachfunktionalität.

Weiterhin kann vorgesehen sein, dass der Oszillator, die Trimmeinrichtung und die Regeleinrichtung auf einem gemeinsamen Chip aufgebaut sind. Dies reduziert den Fertigungsaufwand und die Fertigungskosten deutlich.

Für die Regeleinrichtung zum Regeln der Oszillationsfrequenz kann ferner eine Maximalzeit vorgegeben sein. Dies ist insbesondere im Zusammenhang mit der Kapazitätsmatrix von Vorteil, da die vorgegebenen diskreten Kapazitätswerte in einer vorbestimmten Zeit durchgestimmt werden können.

Entsprechend einer weiteren Ausführungsform ist vorgesehen, dass die Trimmwerte für mehrere Sollfrequenzen des Oszillators in einem Speicher der Hörvorrichtung abgelegt werden. Damit ist der Oszillator für spezielle Modulationsverfahren auf mehrere Modulationsfrequenzen trimmbar.

Die erfindungsgemäße Hörvorrichtung kann ferner eine Zeitsteuereinrichtung aufweisen, um das Trimmen in zeitlich vorgegebenen Abständen zu wiederholen. Die periodische Wiederholung des automatischen Trimmvorgangs ermöglicht effektiv die Kompensation von Alterungs- und Temperaturdrift-Einflüssen. Das Trimmen kann aber auch unmittelbar vor einer Datenübertragung von/zu der Hörvorrichtung oder unmittelbar nach dem Einschalten der Hörvorrichtung angestoßen werden.

Bei entsprechender Konfiguration kann die Hörvorrichtung und insbesondere das Hörgerät die Trimmung nach dem Einschalten auch vollständig autark ausführen, ohne dass die Übertragung von Steuerkommandos an das Hörgerät erforderlich ist. Dadurch kalibriert das Hörgerät den LC-Kreis automatisch und ist somit kurze Zeit nach dem Einschalten auch in der Lage, mit einem drahtlosen Programmiergerät zu kommunizieren. Dieser Punkt ist Grundvoraussetzung für die Realisierbarkeit eines ausschließlich drahtlos programmierbaren Hörgeräts ohne Programmierkontakte.

Unter Umständen wird das Trimmen auch durch einen externen Befehl angestoßen. Die Möglichkeit, die Trimmprozedur über spezielle Steuerkommandos zu starten, verbessert die Test- und Analysemöglichkeiten des Systems und unterstützt das Servicekonzept.

Die vorliegende Erfindung ist anhand der beigefügten Zeichnungen näher erläutert, in denen zeigen:
- FIG 1: den prinzipiellen Aufbau eines Hörgeräts und
- FIG 2: ein Schaltbild eines Teils eines Hörgerätechips mit einem selbsttrimmenden Übertragungssystem.

Das nachfolgend näher geschilderte Ausführungsbeispiel stellt eine bevorzugte Ausführungsform der vorliegenden Erfindung dar.

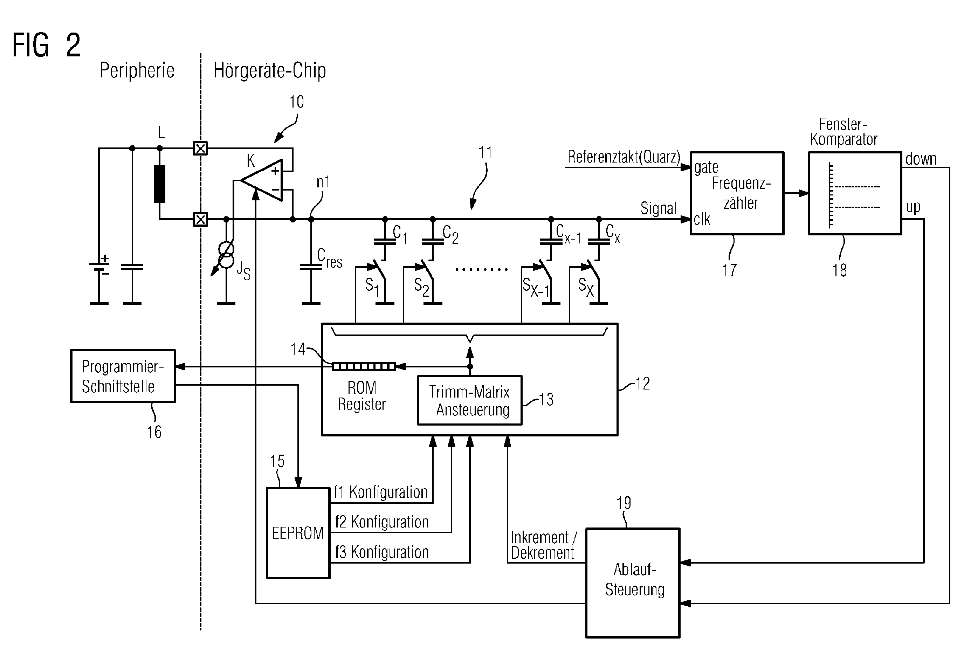

In FIG 2 ist ein Teil eines Hörgeräts dargestellt, dessen Übertragungssystem für eine drahtlose Übertragung sich automatisch selbst trimmen kann. Die meisten der Bauteile befinden sich auf einem Hörgeräte-Chip, während sich eine Sendespule L in der Peripherie des Hörgerätechips, aber innerhalb des Hörgeräts befindet. Die Sendespule L ist an einem Anschluss mit zwei Kondensatoren verbunden, die zur Stabilisierung der Spannung und zum hochfrequenzmäßigen Schließen des Resonanzkreises dienen.

Auf dem Hörgerätechip befindet sich eine Sendeschaltung 10, die als wesentliches Bauteil einen Resonanzkondensator Cᵣₑₛ aufweist, der einerseits an Masse und andererseits über einen Knoten n1 an der Sendespule L liegt. Optional kann zu Cᵣₑₛ zur Frequenzanpassung eine weitere externe Resonanzkapazität parallel geschaltet werden. Ein weiterer wesentlicher Bestandteil der Sendeschaltung ist ein Komparator K, dessen beide Eingänge mit den Anschlüssen der Sendespule L verbunden sind und der ausgangsseitig eine Stromquelle Iₛ steuert. Die Stromquelle Iₛ ist zwischen Masse und den Knoten n1 geschaltet.

Zum Trimmen des Resonanzkondensators Cᵣₑₛ dient eine Kapazitätsmatrix 11, die über den Knoten n1 mit dem Resonanzkondensator Cᵣₑₛ verbunden ist. Die Kapazitätsmatrix 11 verfügt über mehrere Kondensatoren C₁, C₂, ..., Cₓ, die jeweils einerseits an den Knoten n1 und andererseits über einen separaten Schalter S₁, S₂, ..., Sₓ an Masse gelegt sind. Jeder dieser Schalter S₁, S₂, ..., Sₓ wird über eine Steuereinrichtung 12 angesteuert, um den LC-Resonanzkreis zu trimmen und hierfür die entsprechenden Kondensatoren C₁, C₂, ..., Cₓ parallel zu dem Resonanzkondensator Cᵣₑₛ zu schalten. Die Steuereinrichtung 12 enthält als wesentliches Element eine Trimm-Matrix-Ansteuereinheit 13 und außerdem ein ROM-Register 14, über das die Trimmwerte ausgelesen werden können. Als Eingangsparameter erhält die Steuereinrichtung 12 Konfigurationsdaten für unterschiedliche Frequenzen f1, f2, f3 aus einem EEPROM 15. Das EEPROM 15 erhält seinerseits Daten von einer Programmierschnittstelle, die gegebenenfalls die Sendespule L nutzt. Umgekehrt können über die Programmierschnittstelle 16 Trimmwerte aus dem ROM-Register 14 beispielsweise durch ein Programmiergerät (nicht dargestellt) ausgelesen werden.

Der Knoten n1, der das Sendesignal führt, ist weiterhin an einen Frequenzzähler 17 angeschlossen. Letzterer ist außerdem beispielsweise mit einem Quarz verbunden, der einen Referenztakt liefert. Das Ausgangssignal des Frequenzzählers 17 wird einem Fenster-Komparator 18 zugeführt. Dieser analysiert das Frequenzzählersignal dahingehend, ob es in einem vorgegebenen Fenster liegt. Liegt das Frequenzzählersignal über oder unter dem Fenster, so gibt der Fenster-Komparator 18 ein entsprechendes Signal an eine Ablaufsteuerung 19. Diese wiederum liefert ein Inkrement/Dekrement-Signal an die Steuereinrichtung 12, so dass beispielsweise ein Kondensator mehr oder einer weniger an den Resonanzkondensator Cᵣₑₛ geschaltet wird. Die Ablaufsteuerung 19 steuert außerdem den Komparator K an.

Das Selbsttrimmen der Übertragungsschaltung gemäß FIG 2 erfolgt in etwa nach dem folgenden Schema: Durch die Ablaufsteuerung 19 wird zunächst der Sender bzw. sein Komparator K aktiviert. Daraufhin ermittelt der Fenster-Komparator 18, ob der vom Frequenzzähler 17 ermittelte Wert innerhalb des Toleranzbereichs für den Sollwert, d. h. innerhalb des vorgegebenen Fensters, liegt. Ist dies der Fall, so sind keine weiteren Aktionen erforderlich. Liegt der Frequenzwert hingegen zu hoch, wird der Wert der verwendeten Trimmkapazitäten C₁, C₂, ..., Cₓ um ein Inkrement vergrößert. Liegt der Frequenzwert zu niedrig, wird der Wert der Trimmkapazitäten C₁, C₂, ..., Cₓ um ein Inkrement verkleinert. Durch fortgesetzte Wiederholung dieses Verfahren wird nach kurzer Zeit sicher der Zielbereich, d. h. der vom Fenster-Komparator 18 vorgegebene Bereich, erreicht. Als Abbruchkriterium für die Prozedur wird dabei z. B. eine feste Zeit vorgegeben, innerhalb der die maximal mögliche Inkrementanzahl durchlaufen werden kann. Alternativ kann auch das Ausgangssignal des Fenster-Komparators 18 verwendet werden, um das Erreichen des Zielwerts zu detektieren. Hierdurch wird das sonst üblicherweise manuell durchgeführte Verfahren mit den Einzelschritten "Sender aktivieren" - "Frequenz messen" - "Abweichung vom Sollwert ermitteln" - "Kapazitätsmatrix anpassen" automatisiert.

Der durch das automatische Selbsttrimmverfahren ermittelte Trimmwert für die Sollfrequenz kann nach Erreichen des Zielwerts beispielsweise durch ein Programmiergerät ausgelesen und im permanenten EEPROM 15 abgelegt werden. Alternativ kann auch eine direkte Übernahme ins EEPROM 15, getriggert beispielsweise durch einen speziellen Steuerbefehl, realisiert werden. Falls der Resonanzkreis für mehrere unterschiedliche Frequenzen eingestellt werden soll (z. B. für FSK-Modulation), ist der Vorgang für jede der Frequenzen zu wiederholen.

Um die Alterungs- und Temperaturdrift der Bauelementeparameter des LC-Kreises zu kompensieren, wird die oben beschriebene automatische Trimmprozedur in geeigneten zeitlichen Abständen wiederholt. Ein erster Aufruf der Trimmprozedur kann beispielsweise direkt nach dem Einschalten des Hörgeräts erfolgen. Weitere Aufrufe der Trimmprozedur können dann kurz vor einer Datenübertragung erfolgen, so dass damit die korrekte Frequenzeinstellung für jedes übertragene Datum garantiert ist. Alternativ kann auch ein Timer die Prozedur in regelmäßigen Abständen starten.

Zusätzlich kann die Trimmprozedur auch über einen externen Steuerbefehl explizit gestartet werden. Der Steuerbefehl hierfür wird beispielsweise über die drahtgebundene bzw. drahtlose Programmierschnittstelle 16 geschickt.

## Patentansprüche

1. Hörvorrichtung mit
- einem Oszillator (L, Cᵣₑₛ) und
- einer Trimmeinrichtung (11, 12) zum Trimmen der Oszillationsfrequenz des Oszillators,
**gekennzeichnet durch**
- eine Regeleinrichtung (17, 18, 19) zum automatischen Regeln der Oszillationsfrequenz des Oszillators mit Hilfe der Trimmeinrichtung in Abhängigkeit von einem vorgegebenen Sollwert.

2. Hörvorrichtung nach Anspruch 1, wobei der Oszillator (L, Cᵣₑₛ) einen LC-Schwingkreis aufweist, dessen Resonanzkapazität (Cᵣₑₛ) durch eine Kapazitätsmatrix (11) der Trimmeinrichtung (11, 12) trimmbar ist.

3. Hörvorrichtung nach Anspruch 1 oder 2, wobei die Regeleinrichtung (17, 18, 19) einen Frequenzzähler (17), einen Fensterkomparator (18) und eine Ablaufsteuereinheit (19) aufweist.

4. Hörvorrichtung nach Anspruch 2, wobei die Resonanzspule (L) des LC-Schwingkreises eine Sende- und Empfangsantenne darstellt.

5. Hörvorrichtung nach einem der vorhergehenden Ansprüche, wobei eines oder mehrere Schaltungselemente des Oszillators (L, Cᵣₑₛ), die Trimmeinrichtung (11, 12) und die Regeleineinrichtung (17, 18, 19) auf einem gemeinsamen Chip aufgebaut sind.

6. Hörvorrichtung nach einem der vorhergehenden Ansprüche, wobei für die Regeleinrichtung (17, 18, 19) zum Regeln der Oszillationsfrequenz eine Maximalzeit vorgegeben ist.

7. Hörvorrichtung nach einem der vorhergehenden Ansprüche, wobei Trimmwerte für mehrere Sollfrequenzen des Oszillators (L, Cᵣₑₛ) in einem Speicher (15) der Hörvorrichtung ablegbar sind.

8. Hörvorrichtung nach einem der vorhergehenden Ansprüche, die eine Zeitsteuereinrichtung aufweist, um das Trimmen in zeitlich vorgegebenen Abständen zu wiederholen.

9. Hörvorrichtung nach einem der vorhergehenden Ansprüche, wobei das Trimmen unmittelbar vor einer Datenübertragung von/zu der Hörvorrichtung angestoßen wird.

10. Hörvorrichtung nach einem der vorhergehenden Ansprüche, wobei das Trimmen durch einen externen Befehl anstoßbar ist.

11. Verfahren zum Steuern einer Hörvorrichtung durch
- Steuern einer Datenverarbeitung der Hörvorrichtung mit einem Oszillator (L, Cᵣₑₛ) und
- Trimmen der Oszillationsfrequenz des Oszillators,
**dadurch gekennzeichnet, dass**
- das Trimmen ein automatisches Regeln der Oszillationsfrequenz des Oszillators in Abhängigkeit von einem vorgegebenen Sollwert umfasst.

12. Verfahren nach Anspruch 11, wobei zum Regeln der Oszillationsfrequenz eine Maximalzeit vorgegeben ist.

13. Verfahren nach Anspruch 11 oder 12, wobei Trimmwerte für mehrere Sollfrequenzen des Oszillators (L, Cᵣₑₛ) in der Hörvorrichtung gespeichert werden.

14. Verfahren nach einem der Ansprüche 11 bis 13, wobei das Trimmen in zeitlich vorgegebenen Abständen wiederholt wird.

15. Verfahren nach einem der Ansprüche 11 bis 14, wobei das Trimmen unmittelbar vor einer Datenübertragung von/zu der Hörvorrichtung angestoßen wird.

16. Verfahren nach einem der Ansprüche 11 bis 15, wobei das Trimmen durch einen externen Befehl angestoßen wird.
